# EUROPEAN PATENT APPLICATION

(11) **EP 4 383 343 A1**
(43) Date of publication of application: **12.06.2024**
(21) Application number: 23213794.3
(22) Date of filing: 01.12.2023
(51) Int. Cl.: H01L 29/10, H01L 29/744

(54) **SCR STRUCTURE WITH HIGH NOISE IMMUNITY AND LOW SHUNT CURRENT**

(30) Priority: 02.12.2022 CN 202211540405
(71) Applicant: Littelfuse Semiconductor (Wuxi) Co., Ltd., Wuxi, Jiangsu 214142 (CN)
(72) Inventor: Zhou, Jifeng, Wuxi, 214142 (CN); Zhang, Glenda, Wuxi, 214142 (CN); He, Lei, Wuxi, 214142 (CN)
(74) Representative: Arnold & Siedsma

(57) **Abstract**

A silicon controlled rectifier includes a first P region (308), an N- region (310), a second P region (312), and a plurality of N+ regions (314a-e, 328). The first P region is connected to an anode (302). The N- region is adjacent the first P region. The second P region is adjacent the N- region such that the N- region is sandwiched between the first P region and the second P region. The plurality of N+ regions are disposed within the second P region. A first N+ region (314a-e) of the plurality of N+ regions is connected to a cathode (304). A second N+ region (328) of the plurality of N+ regions is connected to a gate (306). The device has a low shunt-current.

## Description

### Field of the Disclosure

Embodiments of the present disclosure relate to silicon controlled rectifiers (SCRs) and, more particularly, to controlling the noise immunity of an SCR.

### Background

Thyristors are semiconductor switches used to control the flow of electrical current. Thyristors are used in applications such as home appliances (lighting, heating, temperature control, alarm activation, fan speed), electrical tools (for controlling motor speed, stapling event, battery charging), and outdoor equipment (water sprinklers, gas engine ignition, electronic displays, area lighting, sports equipment, physical fitness).

One type of thyristor is known as a Silicon Controlled Rectifiers (SCR). Similar to diodes, the SCR is a three-terminal device with a PNPN configuration consisting of an anode terminal connected to a first P section, a cathode terminal connected to a second N section, and a gate terminal connected to the P section nearest the cathode. When a positive voltage is applied at the gate of the device, SCR turns on and will remain on, even if the gate signal is removed. If current flowing through the SCR drops below a latch-on current level, the SCR will turn off. The SCR conducts current only in one direction.

Because a very small amount of current in the gate will activate the SCR, the SCR is sensitive to noise, as the noise may cause device mis-triggering and result in the application circuit malfunction.

It is with respect to these and other considerations that the present improvements may be useful.

### Summary

This Summary is provided to introduce a selection of concepts in a simplified form that are further described below in the Detailed Description. This Summary is not intended to identify key or essential features of the claimed subject matter, nor is it intended as an aid in determining the scope of the claimed subject matter.

An exemplary embodiment of a silicon controlled rectifier in accordance with the present disclosure may include a first P region, an N- region, a second P region, and a plurality of N+ regions. The first P region is connected to an anode. The N- region is adjacent the first P region. The second P region is adjacent the N- region such that the N- region is sandwiched between the first P region and the second P region. The plurality of N+ regions are disposed within the second P region. A first N+ region of the plurality of N+ regions is connected to a cathode. A second N+ region of the plurality of N+ regions is connected to a gate.

### Brief Description of the Drawings

**FIGs. 1A-1C** are diagrams illustrating a silicon controlled rectifier, in accordance with the prior art;
**FIG. 2** is a diagram illustrating a silicon controlled rectifier, in accordance with the prior art;
**FIGs. 3** and **4** are diagrams illustrating a silicon controlled rectifier, in accordance with exemplary embodiments; and
**FIG. 5** is a diagram comparing Igt with dv/dt for the silicon controlled rectifiers of **FIGs. 2** and **4**, in accordance with exemplary embodiments.

### Detailed Description

A silicon controlled rectifier (SCR) is disclosed. Following a sophisticated design in which the N+ region closest the cathode is split into partitioned regions, an additional N+ region is added just below the gate. This has the effect of eliminating the shunt current that characterized the prior art SCR. The novel SCR also enjoys better noise immunity than its prior art counterpart.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

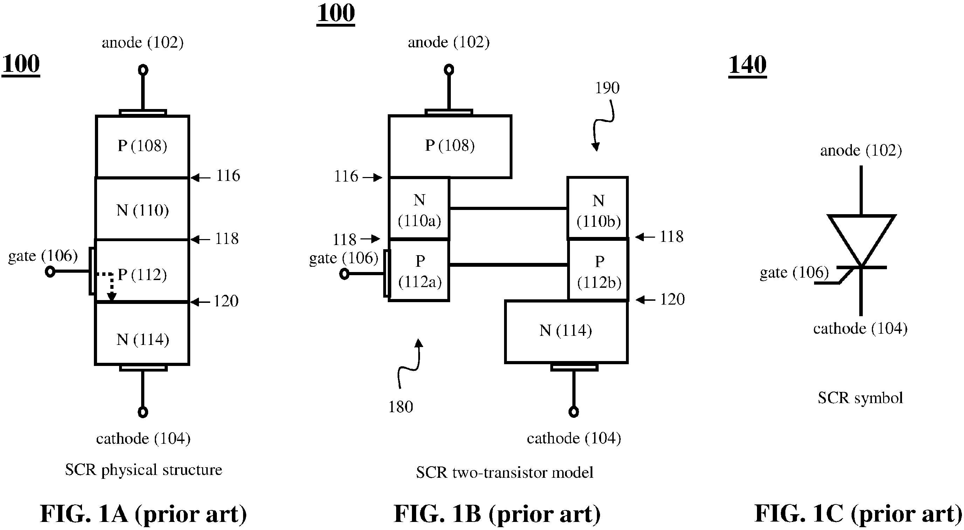

**FIGs. 1A-1C** are representative drawings of a silicon controlled rectifier (SCR), according to the prior art. **FIG. 1A** shows the SCR 100 (physical structure), **FIG. 1B** shows a two-transistor model of the SCR 100, and **FIG. 1C** shows the SCR symbol 140. The SCR 100 is a solid state semiconductor device having four alternating layers 108, 110, 112, and 114 of P-type material and N-type material, with the P-type material being silicon or germanium material doped with an electron acceptor element and the N-type material being silicon or germanium material doped with an electron donor element. More particularly, the SCR 100 is made up of a P layer 108, an N layer 110, a P layer 112, and an N layer 114.

The SCR 100 is a three-terminal device having an anode 102 coupled to the top P layer 108, a cathode 104 coupled to the N layer 114 and a gate 106 coupled to the P layer 112. The SCR symbol 140 is shown in **FIG. 1C****.** The SCR is a unidirectional device, allowing current to flow in one direction, from anode 102 to cathode 104. SCRs are designed to control a relatively large amount of power and voltage with a small device.

The SCR 100 features three junctions 116, 118, and 120. Junction 116 is the junction between the P layer 108 and the N layer 110; junction 118 is the junction between the N layer 110 and the P layer 112; and junction 120 is the junction between the P layer 112 and the N layer 114. Junction 120 is also known as the gate cathode junction. These junctions exhibit different behaviors based on the voltage to the terminals. If the anode 102 is given a positive potential with respect to the cathode 104, then junctions 116 and 120 are forward-biased while junction 118 is reverse-biased. If on the other hand, the anode 102 is given a negative potential with respect to the cathode 104, then junctions 116 and 120 are reverse-biased while junction 118 is forward-biased.

When a positive voltage is applied at the gate 106 of the device, the gate cathode junction 120 will become forward biased. This allows the SCR 100 to turn on (current flowing from cathode to anode). A dotted arrow in **FIG. 1A** shows the effect of issuing a positive voltage at the gate 106 to the gate cathode junction 120. Once the SCR 100 turns on, it will remain on even if the gate signal is removed. An SCR acts much like a regular forward bias diode. The SCR remains on as long as the current flowing through the device remains above it's latch-on current level. When the SCR drops below this level, it turns back off. The ability to remain on even after the triggering signal is removed is referred to as latching.

Igt, the gate trigger current, is the minimum gate current required to switch an SCR from the off state to the on state. Vgt, the gate trigger voltage, is the voltage required to produce the gate trigger current. SCRs are activated (turned on) by the presence of a positive gate signal with respect to the cathode polarity, with a brief pulse of Igt generally being sufficient.

The prior art SCR 100 may also be described according to a two-transistor model, as illustrated in **FIG. 1B****.** The N region 110 and P region 112 of the PNPN model are split into N layers 110a and 110b and P layer 112a and 112b. As before, the anode 102 is coupled to the P layer 108, the cathode 104 is coupled to the N layer 114 and the gate 106 is coupled to one side of the P layer 112a. The two-transistor model is simply the PNPN model of **FIG. 1A****,** bisected so that there are two transistors 180 and 190, the transistor 180 being a PNP transistor with junctions 116 and 118 and the transistor 190 being an NPN transistor with junctions 118 and 120.

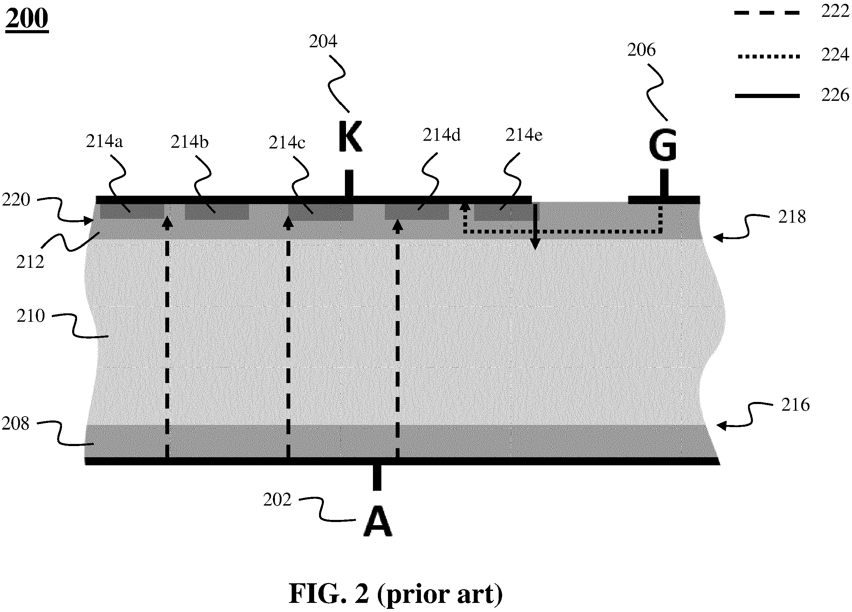

**FIG. 2** is a representative drawing of an SCR 200, according to the prior art. The SCR 200 is a sophisticated design structure of the PNPN configuration shown in **FIG. 1A****.** An anode 202 is connected to a P region 208, which is adjacent an N- region 210. A second P region 212 is adjacent the N- region 210, such that the N- region 210 is sandwiched between the two P regions 208 and 212. A final N+ region of the SCR 200 consists of multiple disjointed N+ regions 214a-214e (collectively, "N+ region(s) 214"). A gate 206 is connected to the second P region 212 and a cathode 204 (denoted "K") is connected to the N+ region 214c.

The SCR 200 features three junctions 216, 218, and 220. Junction 216 is the junction between the P region 208 and the N- region 210; junction 218 is the junction between the N- region 210 and the P region 112; and junction 220 is the junction between the P region 212 and the N+ region 214. Junction 220 is also known as the gate cathode junction. As with the SCR 100, the junctions exhibit different behaviors based on the voltage to the terminals. If the anode 202 is given a positive potential with respect to the cathode 204, then junctions 216 and 220 are forward-biased while junction 218 is reverse-biased. If on the other hand, the anode 202 is given a negative potential with respect to the cathode 204, then junctions 216 and 220 are reverse-biased while junction 218 is forward-biased.

Dashed lines 222, dotted lines 224, and a solid arrow 226 denote electron/current paths. Dashed lines 222 denote the electron flow between anode 202 and cathode 204. The SCR 200 is triggered such that current flows between anode 202 and cathode 204 by adding a positive bias on the gate 206.

As with the SCR 100, for the SCR 200, when a positive voltage is applied at the gate 206, the gate cathode junction 220 will become forward biased, which allows the SCR 200 to turn on. However, because of the disjointed N+ regions 214, current will flow through the "shorted dots" between the disjointed N+ regions 214 and the P region 212 before the gate cathode junction 220 (N+P region) becomes forward biased. Electrons need to go through from the gate through this shorting area (the shorted dots) because there is a resistance path without any PN junction area, which results in the occurrence of a shunt current, given by the dotted line 224, before the gate cathode junction 220 can be forward biased.

In addition to the shunt current given by dotted line 224, the solid arrow 226 is an electron ejection region. With a positive gate bias used to turn the SCR 200 on, electrodes in the cathode region 204 close to the gate area 206 will be injected into the N- region 210 through the P region 212. This is shown in the solid arrow 226.

With reference to the two-transistor model (**FIG. 1B**) of the SCR 100, the N+ region 214, P region 212, and N region 210 of the SCR 200 corresponds to the first transistor 180 and the P region 208, N region 210, and P region 212 of the SCR 200 corresponds to the second transistor 190. The connection of the two transistors triggers the occurrence of regenerative action when a proper gate signal is applied to the base of the first NPN transistor. A momentary positive pulse applied to the gate biases the first NPN transistor into conduction which, in turn, biases the second PNP transistor into conduction. The effective hFE, a measure of the DC gain of a junction transistor, momentarily becomes greater than unity so that specially coupled transistors saturate. Once saturated, current through the transistors is enough to keep the combined hFE greater than unity, and the device maintains an "on" state. The SCR 200 will thus turn on due to current regeneration of N+PN (first transistor) and PNP (second transistor).

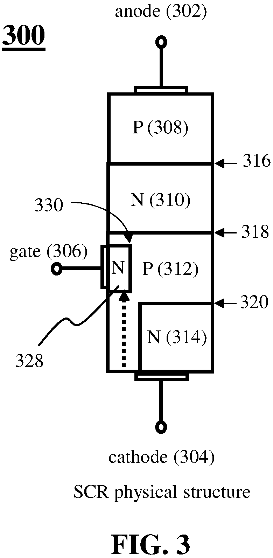

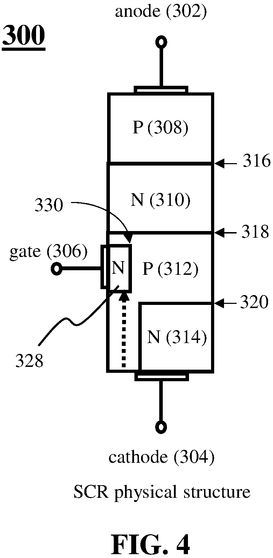

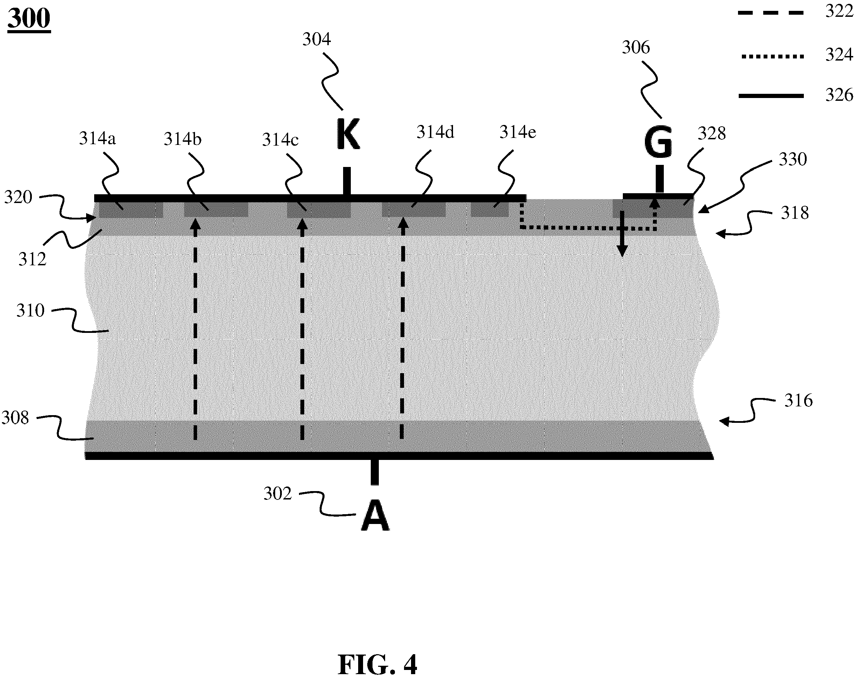

**FIGs. 3** **and** **4** are representative drawings of an SCR 300, according to exemplary embodiments. **FIG. 3** shows the physical structure of the SCR 300 while **FIG. 4** shows the semiconductor structure. Like the SCR 200, the SCR 300 is a sophisticated design structure of a PNPN configuration. However, as shown in FIG. 3, the configuration is different from that shown in **FIG. 1A****.** An anode 302 is connected to a P region 308, which is adjacent an N- region 310. A second P region 312 is adjacent the N- region 310, such that the N- region 310 is sandwiched between the two P regions 308 and 312. The second P region 312 extends to a cathode 304 (denoted "K"), with a final N+ region 314 being smaller than the N- region 310 and contained within the second P region 312. In the semiconductor structure of **FIG. 4****,** the N+ region 314 of the SCR 300 consists of multiple disjointed N+ regions 314a-314e (collectively, "N+ region(s) 314"). In exemplary embodiments, the SCR 300 further includes an N+ region 328 at gate 306, which is disposed within the second P region 312. The cathode 304 is connected to the N+ region 314c.

Like the SCR 100 and the SCR 200, the exemplary SCR 300 features three junctions 316, 318, and 320, plus an additional PN+ junction 330 at the gate 306. Junction 316 is the junction between the P region 308 and the N- region 310; junction 318 is the junction between the N- region 310 and the P region 312; and junction 320 is the junction between the P region 312 and the N+ regions 314. Junction 320 is also known as the gate cathode junction. With a negative bias at the gate 306, the junction 330 will be forward biased, and the N+ region 328 in the gate area will inject electrons into the N- region 310 and will activate (turn on) the SCR 300. With a positive bias at the gate 306, the junction 330 will be reverse biased, and no electrons will be injected into the N+ region. Thus, the SCR 300 will remain inactive (turned off).

By doping the gate area with the N+ region 328, electrons in the gate 306 will more easily be injected into the N- region 310 if there is a negative gate bias. A sub emitter resistance is the resistance of the region sandwiched between the N+ region 314 and the P region 312 (see dotted arrow in **FIG. 4**), which makes the sub emitter resistance of the cathode region 304 much lower, given the same Igt level. In exemplary embodiments, this decreases N+PN current gain and improves static dv/dt with lower Igt.

Dashed lines 322, dotted lines 324, and a solid arrow 326 in **FIG. 4** denote electron/current paths. Dashed lines 322 denote the electron flow between anode 302 and cathode 304. Dotted lines 324 indicate the negative gate bias (Igt) current flow through the SCR 300. The solid arrow 326 is an electron ejection region. With a negative gate bias used to turn the SCR 300 on, electrodes in the gate region close to the cathode area will be injected into the N- region 310 through the P region 312. This is shown in the solid arrow 326. Using the two-transistor analogy, the SCR 300 will turn on due to current regeneration of N+PN (e.g., the first transistor) and PNP (e.g., the second transistor). The connections between the two transistors trigger the occurrence of regenerative action when a proper gate signal is applied to the base of the NPN transistor. A momentary negative pulse applied to the gate 306 biases the NPN (first) transistor into conduction which, in turn, biases the PNP (second) transistor into conduction. The effective hFE momentarily becomes greater than unity so that the specially coupled transistors saturate. Once saturated, current through the transistors is sufficient to keep the combined hFE greater than unity, such that the SCR 300 maintains its "on" state.

Comparing the SCR 300 to the SCR 200, in exemplary embodiments, it is easier to inject electrons (and therefore activate) the SCR 300 than the SCR 200 because there is no emitter shorting. Accordingly, the current gain of N+PN (first transistor) of the cathode 304 area could be much lower, making the SCR 300 less sensitive and more immune to noise than the SCR 200. Further, there is no shunt current occurring in the SCR 300, in contrast to the SCR 200.

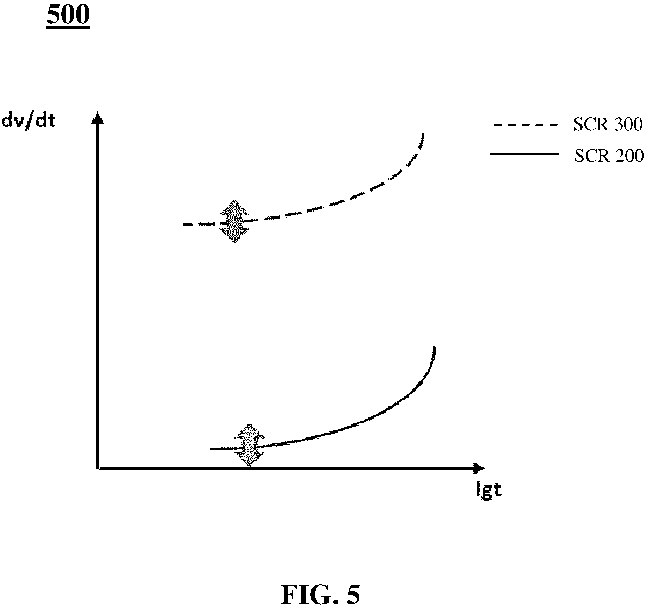

**FIG. 5** is a representative graph 500, according to exemplary embodiments. The graph 500 is a comparison between the prior art SCR 200 and the exemplary SCR 300 and plots Igt versus dv/dt. The double arrows in each graph plot indicate that there may be some fluctuation of these values. In exemplary embodiments, with approximately the same Igt, the dv/dt of the SCR 300 is much higher than that of the SCR 200. A higher dv/dt means the SCR 300 is not as sensitive to rapid changes of voltage (e.g., spikes), and is thus more immune to noise and less likely to be mistriggered. With the same Igt level, the internal transistor gain of the SCR 300 is significantly different than that of the SCR 200, in some embodiments.

As used herein, an element or step recited in the singular and proceeded with the word "a" or "an" should be understood as not excluding plural elements or steps, unless such exclusion is explicitly recited. Furthermore, references to "one embodiment" of the present disclosure are not intended to be interpreted as excluding the existence of additional embodiments that also incorporate the recited features.

While the present disclosure refers to certain embodiments, numerous modifications, alterations, and changes to the described embodiments are possible without departing from the sphere and scope of the present disclosure, as defined in the appended claim(s). Accordingly, it is intended that the present disclosure is not limited to the described embodiments, but that it has the full scope defined by the language of the following claims, and equivalents thereof.

## Claims

1. A silicon controlled rectifier comprising:
a first P region coupled to an anode;
an N- region adjacent the first P region;
a second P region adjacent the N- region, wherein the N- region is sandwiched between the first P region and the second P region; and
a plurality of N+ regions disposed within the second P region, wherein:
a first N+ region of the plurality of N+ regions is coupled to a cathode; and
a second N+ region of the plurality of N+ regions is coupled to a gate.

2. The silicon controlled rectifier of claim 1, further comprising:
a first junction between the first P region and the N- region.

3. The silicon controlled rectifier of claim 2, further comprising:
a second junction between the N- region and the second P region.

4. The silicon controlled rectifier of claim 3, further comprising:
a third junction between the second P region and the plurality of N+ regions.

5. The silicon controlled rectifier of claim 4, further comprising:
a fourth junction between the second N+ region and the second P region.

6. The silicon controlled rectifier of claim 1, wherein there is no shunt current.

7. The silicon controlled rectifier of claim 2, further to be turned on by a negative gate bias.

8. The silicon controlled rectifier of claim 2, further to be turned off by a positive gate bias.
